(19) **Europäisches Patentamt / European Patent Office / Office européen des brevets**

(11) **EP 2 682 768 B1**

(12) **EUROPEAN PATENT SPECIFICATION**

(45) Date of publication and mention
of the grant of the patent:
**15.10.2014 Bulletin 2014/42**

(51) Int Cl.:
**G01R 31/08** (2006.01)

(21) Application number: **12174738.0**

(22) Date of filing: **03.07.2012**

(54) **Method and apparatus for determining the distance to phase-to-earth fault**

Verfahren und Vorrichtung zur Bestimmung der Distanz zum Erdschluss

Procédé et appareil pour déterminer la distance à un défaut de phase à la terre

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.01.2014 Bulletin 2014/02**

(73) Proprietor: **ABB Technology AG**
**8050 Zürich (CH)**

(72) Inventors:
• **Wahlroos, Ari**
**65320 Vaasa (FI)**

• **Altonen, Janne**
**33720 Tampere (FI)**

(74) Representative: **Kolster Oy Ab**
**Iso Roobertinkatu 23**
**PO Box 148**
**00121 Helsinki (FI)**

(56) References cited:
**EP-A1- 1 939 638        EP-A1- 2 000 811**
**US-A1- 2006 291 113     US-A1- 2008 297 163**
**US-A1- 2009 267 611**

**Description**

FIELD OF THE INVENTION

The invention relates to determining a distance to a phase-to-earth fault on a three-phase electric line of an electric network.

BACKGROUND OF THE INVENTION

In recent years earth-fault location in high-impedance earthed networks, especially in compensated networks, using fundamental frequency phasors has been under research and development in order to find a practically applicable solution for fault distance estimation.

Document:

* J. Altonen, A. Wahlroos, "Advancements in fundamental frequency impedance based earth-fault location in unearthed distribution networks", CIRED 2007, Vienna

discloses a method for locating earth-faults in unearthed networks.

Documents:

* J. Altonen, A. Wahlroos, "Advancements in earth-fault location in compensated MV-networks", CIRED 2011, Frankfurt
* S. Hänninen, M. Lehtonen, "Earth fault distance computation with fundamental frequency signals based on measurements in substation supply bay", VTT Research Notes 2153, Espoo 2002 and
* P. Schegner, G. Eberl, "Computation of the earth fault distance in compensated MV-networks by evaluating steady-state values", PSCC, Sevilla 2002

disclose methods utilizing changes in measured voltages and currents during the fault. The change during the fault may be obtained by changing the impedance of a compensation coil, for example. Typically this means the connection or disconnection of a parallel resistor of a compensation coil or a change in the compensation degree of the compensation coil. However, the change can be any change in the neutral to earth admittance of the electric network outside the measured electric line during the fault. Alternatively the change measurable in voltages and current may be caused for example by a current injection device connected into the system neutral point.

What is common to these known prior-art methods applicable in compensated networks is that they solve fault distance d and fault resistance $R_F$ from a set of equations consisting of two equations based on an equivalent circuit valid for a single-phase earth-fault:

* one equation is valid at a time instance before the change during the fault and the other equation is valid at a time instance after the change during the fault or
* one equation represents the real part of the equation valid for single-phase earth-fault describing the change during the fault, and the other equation represents the imaginary part of the equation valid for single-phase earth-fault describing the change during the fault.

Typically phase currents, phase-to-earth voltages, residual current and residual voltage are required as measurements. Positive- and negative-sequence symmetrical components, phase adjusted according to the faulted phase, can be derived from such measurements with well-known equations.

Line impedances are typically required as setting parameters: positive-sequence resistance $R_1$, positive-sequence reactance $X_1$, zero-sequence resistance $R_0$ and zero-sequence reactance $X_0$.

In addition, in all the above prior-art fault location algorithms, the shunt admittance of the line, $\overline{Y}_0 = G_0 + j*B_0$, consisting of conductance $G_0$ and susceptance $B_0$, is also required. This setting parameter is used to estimate the fault current at the fault location and the voltage drop over the zero-sequence impedance from the measuring point to the fault. Further, a setting parameter $q$, distribution factor for the zero-sequence current of the line, is needed in order to calculate the part of the zero-sequence charging current component that is causing a voltage drop over the zero-sequence impedance from the measuring point to the fault point.

Typically the longitudinal positive-sequence line parameters ($R_1$, $X_1$) are known and available from DMS (Distribution Management System), but the exact values for longitudinal zero-sequence line parameters ($R_0$, $X_0$) are more or less approximations based on the general line theory. These parameters can also be measured, if necessary, with dedicated equipment.

Initial value for parameter $\overline{Y}_0 = G_0 + j{*}B_0$ can be obtained from the DMS, but for sufficient practical accuracy it should be measured and constantly updated to match the current switching-state of the line. Such a measuring and updating procedure could be based on e.g. current injection techniques, which require dedicated equipment for this purpose. The influence of the accuracy of setting parameter $\overline{Y}_0 = G_0 + j{*}B_0$ on the fault distance estimation has been found to be very important. This is especially true if the requirement for fault resistance coverage of a meaningful earth-fault location is extended from solid faults to low-ohmic faults. On the basis of the results given in document J. Altonen, A. Wahlroos, "Advancements in earth-fault location in compensated MV-networks", CIRED 2011, Frankfurt, already an error of 5% in $\overline{Y}_0$ is enough to make the validity of the fault distance poor at fault resistance values in the range of a few hundred ohms. This is due to the fact that parameter $\overline{Y}_0$ is used in the fault location methods to estimate the fault current at the fault location and the voltage drop over the zero-sequence impedance from the measurement point to fault. The correctness of these terms is imperative for the overall fault distance calculation procedure. The requirement for accuracy for the parameter $\overline{Y}_0$ can exceed the practically available accuracy e.g. from DMS data or approximations given in theory books.

The value of parameter $q$, distribution factor for zero-sequence current of the line, may also be a setting parameter, but it is typically fixed to a value of 0.5 based on an assumption of evenly distributed shunt admittance of the line. If the actual distribution is different, then this approximation introduces an error to the computational fault location.

EP 1939638 discloses a method for determining a distance of a phase-to-earth fault on a three-phase electric line, comprising determining a first estimate value for a distance between the measuring point and a point of fault on the basis of a first equation based on a fault loop model of the electric line, in which model the load of the electric line is located between the measuring point and the point of fault; determining a second estimate value for the distance on the basis of a second equation based on a fault loop model of the electric line, in which model the point of fault is located between the measuring point and load of the electric line; and selecting, according to predetermined criteria, one of the determined two estimate values as the distance between the measuring point and the point of fault.

EP 2000811 discloses a method for determining a location of a phase-to-earth fault on a three-phase electric line of an electric network, comprising determining an equivalent load distance curve of the electric line representing a voltage drop along the electric line scaled by an equivalent load distance of the electric line, determining a fault distance line indicating an estimate of a distance of the fault from the measuring point in relation to the equivalent load distance, determining a distance at which the equivalent load distance curve and the fault distance line intersect when superimposed, and selecting the determined distance as the distance between the measuring point and the point of fault.

US 2009/0267611 discloses a method for determining a distance of a phase-to-phase fault or a three-phase fault on a three-phase electric line, comprising determining a first estimate value for a distance between the measuring point and a point of fault on the basis of a first equation based on a fault loop model in which the point of fault is located between the measuring point and load of the electric line; determining a second estimate value for the distance on the basis of a second equation based on a fault loop model in which the load of the electric line is located between the measuring point and the point of fault; and selecting according to predetermined criteria one of the determined two estimate values as the distance between the measuring point and the point of fault.

US 2006/0291113 discloses a method for determining a location of a phase-to-earth fault in a three-phase electric line of an electric network, comprising monitoring current and voltage quantities of the three-phase electric line at a measuring point; calculating load-compensated zero and negative sequence currents by using a total zero sequence admittance of the electric network and a zero sequence admittance of the electric network without the faulted electric line and by using a negative sequence current of the faulted phase and a zero sequence current; calculating a load-compensated phase voltage of the faulted phase by using the compensated zero sequence current; and calculating a distance between the measuring point and a point of fault using the compensated negative sequence current and the compensated phase voltage and an equation relating the current and voltage quantities to the distance.

US 2008/0297163 discloses a method for determining a location of a phase-to-earth fault on a three-phase electric line of an electric network, comprising determining, when the ratio of a fault current and load current has a first value, a first fault distance line which indicates an estimate of a distance of the fault from the measuring point in relation to an equivalent load distance, determining, when the ratio of the fault current and load current has a second value which differs from the first value, at least one second fault distance line, determining a distance at which the determined fault distance lines intersect when superimposed and determining the distance between the measuring point and the point of fault on the basis of the determined distance or distances of intersection.

BRIEF DESCRIPTION OF THE INVENTION

An object of the present invention is thus to provide a method and an apparatus for implementing the method so as to overcome the above problems or at least to alleviate them. The objects of the invention are achieved by a method and an arrangement, which are characterized by what is stated in the independent claims. The preferred embodiments of the invention are disclosed in the dependent claims.

The invention is based on the idea of determining the distance to the phase-to-earth fault from the measuring point by using four equations derivable from an equivalent circuit for a phase-to-earth fault on a three-phase electric line.

An advantage of the method and arrangement of the invention is that they enable the fault distance estimation without the setting parameters $\overline{Y}_0$ and $\boldsymbol{q}$, although their influence is still included in the fault distance estimation. This means that there is no need to determine and set parameters $\overline{Y}_0$ and $\boldsymbol{q}$. Due to these advantages, the present invention enables an accurate fault location in e.g. compensated networks at fault resistance values in the range of a few hundred ohms.

BRIEF DESCRIPTION OF THE DRAWINGS

In the following the invention will be described in greater detail by means of preferred embodiments with reference to the accompanying drawings, in which

Figure 1 is a diagram illustrating an electric network according to an embodiment; and
Figure 2 is an equivalent circuit according to an embodiment.

DETAILED DESCRIPTION OF THE INVENTION

The application of the invention is not limited to any specific system, but it can be used in connection with various three-phase electric systems to determine a distance to a phase-to-earth fault on a three-phase electric line of an electric network. The electric line can be a feeder, for example, and may be an overhead-line or a cable or a combination thereof. The electric power system in which the invention is implemented may be an electric transmission or distribution network or a component thereof, for example, and may comprise several feeders or sections. Moreover, the use of the invention is not limited to systems employing 50 Hz or 60 Hz fundamental frequencies or to any specific voltage level.

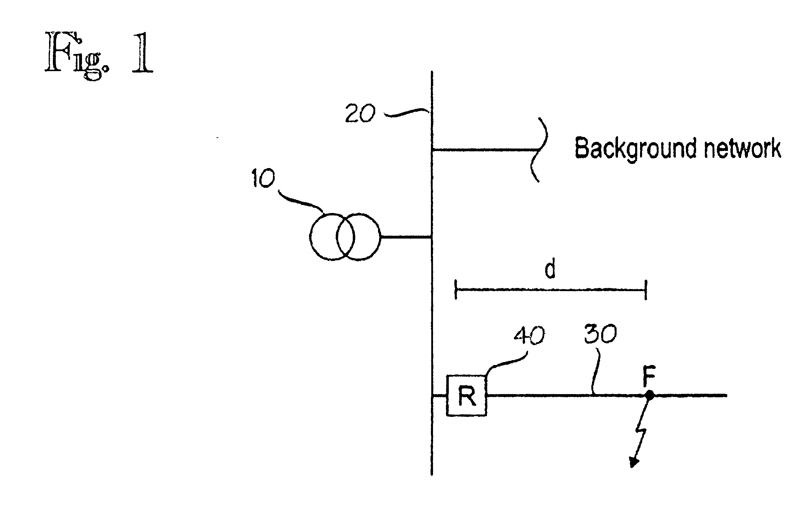

Figure 1 is a simplified diagram illustrating an electric network in which the invention can be applied. The figure shows only the components necessary for understanding the invention. The exemplary network may be a medium voltage (e.g. 20 kV) distribution network fed through a substation comprising a transformer 10 and a busbar 20. The illustrated network also comprises electric line outlets, i.e. feeders, of which one 30 is shown separately. Other possible feeders as well as other network parts, except the line 30, are referred to as a 'background network'. The figure also shows a protective relay unit (R) 40 at the beginning of the line 30, and a point of earth fault F. The protective relay unit 40 may be located inside the substation. It should be noted that there may be any number of feeders or other network elements in the network. There may also be several feeding substations. Further, the invention can be utilized with a switching station without a transformer 10, for example. The network is a three-phase network, although, for the sake of clarity, the phases are not shown in the figure. In the exemplary system of Figure 1, the functionality of the invention may be located in the relay unit 40, for example. It is also possible that e.g. only some measurements are performed at the location of unit 40 and the results are then transmitted to another unit or units (not shown in the figures) at another location for further processing. In other words, the relay unit 40 could be a mere measuring unit, while the functionality of the invention, or part of it, could be located in another unit or units.

Current and voltage values that are needed in the following embodiments may be obtained by a suitable measuring arrangement including e.g. current and voltage transducers (not shown in the figures). In most of the existing protection systems, such values are readily available and thus the implementation of the various embodiments does not necessarily require any additional measuring arrangements. A zero-sequence voltage of the electric network may be determined from phase voltages measured at e.g. the relay unit 40, or at another location. The zero-sequence voltage of the electric network may also be determined by measuring it from an open delta winding formed by voltage transformers, for example. A phase-to-earth voltage of a faulted phase of the electric line 30 may be determined with a suitable voltage measuring arrangement, for example, at a measuring point, such as the relay unit 40. A zero-sequence current, a positive-sequence current and a negative-sequence current of the electric line 30 may be determined with a suitable current measuring arrangement, for example, at the measuring point, such as the relay unit 40. How these and possible other current and voltage values are obtained depends, however, on the particular electricity system. A phase-to-earth fault F occurring on the three-phase electric line 30 and the corresponding faulted phase may be detected e.g. by the protective relay 40 associated with the electricity system. The particular way how the phase-to-earth fault is detected and the corresponding faulted phase is identified is of no relevance to the basic idea of the invention.

According to an embodiment the distance to the fault F from the measuring point, such as the relay unit 40, may be determined when, during a phase-to-earth fault, a neutral to earth admittance of the electric network outside the electric line 30 changes from a first value to a second value different from the first value. The change during the fault may be obtained by changing the impedance of a compensation coil, for example. Typically this means the connection or disconnection of a parallel resistor of a compensation coil or a change in the compensation degree of the compensation coil. But the change can be any change in the neutral to earth admittance of the electric network outside the electric line 30 during the fault. Alternatively the change measurable in voltages and currents may be caused for example by a current injection device connected to the system neutral point. Therefore the invention is not limited to Petersen coil compensated networks.

According to an embodiment, the determination of the distance to the fault F from the measuring point, such as the relay unit 40, comprises determining, during a phase-to-earth fault F on the three-phase electric line 30, when the neutral to earth admittance of the electric network outside the electric line 30 has the first value, the following:

* a value of the zero-sequence voltage of the electric network,
* a value of the phase-to-earth voltage of a faulted phase of the electric line at the measuring point,
* a value of the zero-sequence current of the electric line at the measuring point,
* a value of the positive-sequence current of the electric line at the measuring point and
* a value of the negative-sequence current of the electric line at the measuring point.

Further, the determination of the distance to the fault F from the measuring point comprises determining, during the phase-to-earth fault F on the three-phase electric line 30, when the neutral to earth admittance of the electric network outside the electric line 30 has the second value different from the first value, the following:

* a value of the zero-sequence voltage of the electric network,
* a value of the phase-to-earth voltage of a faulted phase of the electric line at the measuring point,
* a value of the zero-sequence current of the electric line at the measuring point,
* a value of the positive-sequence current of the electric line at the measuring point and
* a value of the negative-sequence current of the electric line at the measuring point.

After the determination of the above values, the distance to the phase-to-earth fault F from the measuring point 40 can be determined on the basis of the determined current and voltage values.

The positive-sequence and negative-sequence currents of the electric line at the measuring point are preferably phase adjusted according to the faulted phase on the basis of the well-known theory of symmetrical components:

$$
\begin{array}{llll}
\text{Faulted phase L1:} & \underline{I}_{2L1} = \underline{I}_2 & \underline{I}_{1L1} = \underline{I}_1 \\
\text{Faulted phase L2:} & \underline{I}_{2L2} = \underline{a} \cdot I_2 & \underline{I}_{1L2} = \underline{a}^2 \cdot I_1 \\
\text{Faulted phase L3:} & \underline{I}_{2L3} = \underline{a}^2 \cdot I2 & \underline{I}_{1L3} = \underline{a} \cdot I_1 \\
\end{array}
$$

Where
$\underline{I}_1$ = positive sequence current component = $(\underline{I}_{L1} + \underline{a} \cdot \underline{I}_{L2} + \underline{a}^2 \cdot I_{L3})/3$
$\underline{I}_2$ = negative sequence current component = $(\underline{I}_{L1} + \underline{a}^2 \cdot \underline{I}_{L2} + \underline{a} \cdot \underline{I}_{L3})/3$
$\underline{a} = 1 \angle 120°$,
$\underline{a}^2 = 1 \angle 240°$

According to an embodiment, the fault distance d is determined by using four equations derivable from an equivalent circuit for a phase-to-earth fault on a three-phase electric line.

The first equation preferably relates a real part of the phase-to-earth voltage of the faulted phase at the measuring point to the zero-sequence voltage of the electric network and to the zero-sequence current, the positive-sequence current and the negative-sequence current of the electric line at the measuring point, when the neutral to earth admittance of the electric network outside the electric line has the first value.

The second equation preferably relates an imaginary part of the phase-to-earth voltage of the faulted phase at the measuring point to the zero-sequence voltage of the electric network and to the zero-sequence current, the positive-sequence current and the negative-sequence current of the electric line at the measuring point, when the neutral to earth admittance of the electric network outside the electric line has the first value.

The third equation preferably relates the real part of the phase-to-earth voltage of the faulted phase at the measuring point to the zero-sequence voltage of the electric network and to the zero-sequence current, the positive-sequence current and the negative-sequence current of the electric line at the measuring point, when the neutral to earth admittance of the electric network outside the electric line has the second value.

Finally, the fourth equation preferably relates the imaginary part of the phase-to-earth voltage of the faulted phase at the measuring point to the zero-sequence voltage of the electric network and to the zero-sequence current, the positive-sequence current and the negative-sequence current of the electric line at the measuring point, when the neutral to earth admittance of the electric network outside the electric line has the second value.

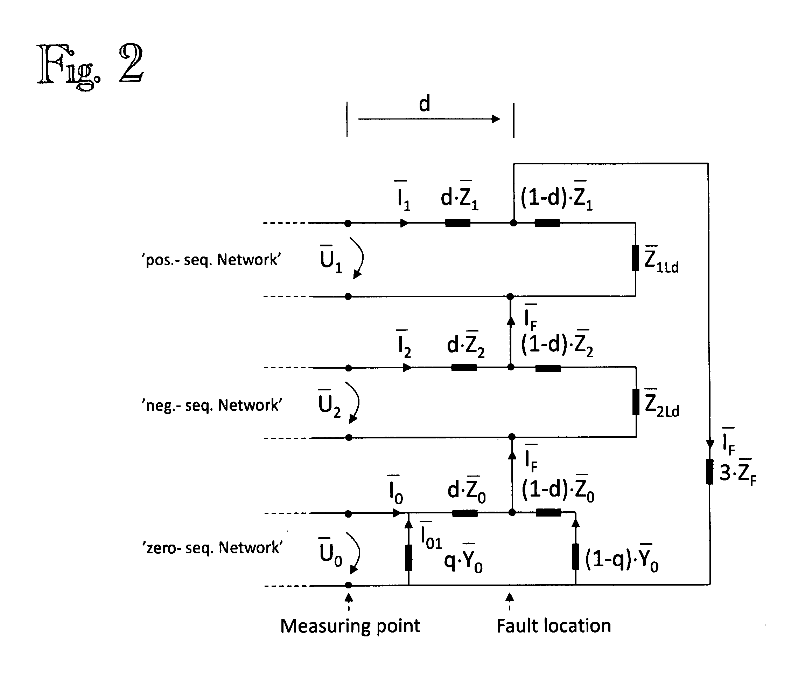

Figure 2 illustrates a simplified equivalent circuit of a phase-to-earth fault on an electric line according to an embodiment. It should be noted that the equivalent circuit of Figure 2 is merely one example of possible equivalent circuits of a phase-to-earth fault on an electric line. Thus, the form of the equivalent circuit may vary from that shown in Figure 2. The following notations are used in Figure 2:

$d$ = Per unit fault distance ($d$ = 0...1)

$\overline{Z}_1$ = $R_1$ +j*$X_1$ = Positive-sequence impedance of the electric line

$R_1$ = Positive-sequence resistance of the electric line

$X_1$ = Positive-sequence reactance of the electric line

$\overline{Z}_{1Ld}$ = Positive-sequence impedance of the load

$\overline{Z}_2$ = $R_2$ +j*$X_2$ = Negative-sequence impedance of the electric line

$R_2$ = Negative-sequence resistance of the electric line

$X_2$ = Negative-sequence reactance of the electric line

$\overline{Z}_{2Ld}$ = Negative-sequence impedance of the load

$\overline{Z}_0$ = $R_0$ +j*$X_0$ = Zero sequence-impedance of the electric line

$R_0$ = Zero-sequence resistance of the electric line

$X_0$ = Zero-sequence reactance of the electric line

$\overline{Y}_0$ = $G_0$ +j*$B_0$ = Phase-to-earth admittance of the electric line per phase

$G_o$ = Phase-to-earth conductance of the electric line per phase

$B_0$ = Phase-to-earth susceptance of the electric line per phase

$\overline{Z}_F$ = $R_F$ +j*$X_F$ = Fault impedance

$R_F$ = Fault resistance

$X_F$ = Fault reactance

$\overline{I}_1$ = Positive-sequence current measured at the measuring point

$\overline{I}_2$ = Negative-sequence current measured at the measuring point

$\overline{I}_0$ = Zero-sequence current measured at the measuring point

$\overline{I}_{01}$ = The part of the zero-sequence charging current of the electric line which flows through impedance $d\cdot\overline{Z}_0$

$q$ = Distribution factor for zero-sequence current of the electric line

$\overline{I}_F$ = Fault component current at fault point (actual fault current equals $3\cdot\overline{I}_F$)

$\overline{U}_1$ = Positive-sequence voltage measured at the measuring point

$\overline{U}_2$ = Negative-sequence voltage measured at the measuring point

$\overline{U}_0$ = Zero-sequence voltage of the electric network

On the basis of the equivalent circuit of Figure 2, the following equation can be written:

$$\overline{U}_{ph} = d\cdot\overline{Z}_0\cdot(\overline{I}_0 - \overline{U}_0\cdot\overline{Y}_0\cdot q) + d\cdot\overline{Z}_1\cdot\overline{I}_1 + d\cdot\overline{Z}_2\cdot\overline{I}_2 + 3\cdot R_F\cdot(\overline{I}_0 - \overline{U}_0\cdot\overline{Y}_0) \qquad \text{Eq.1}$$

where

$\overline{U}_{ph}$ = $\overline{U}_0 + \overline{U}_1 + \overline{U}_2$ = phase-to-earth voltage of the faulted phase at the measuring point

For electrical conductors, it can be assumed that the negative sequence impedance equals the positive sequence impedance, i.e. $\overline{Z}_2 = \overline{Z}_1$.

In the exemplary equivalent circuit of Figure 2, the current which flows through the zero-sequence impedance $d\cdot\overline{Z}_0$ from the measuring point to the fault point includes two parts: The part which can be measured is the zero-sequence current $\overline{I}_0$. The non-measurable part is due to the phase-to-earth admittance of the electric line itself from the measuring point to the fault point and its value has to be estimated. Typically, the estimation is based on an approximation that this part of the current is proportional to fault distance $d$ with parameter $q$. Parameter $q$ is used as a distribution factor for the charging current of the electric line. Parameter $q$ represents how capacitances are distributed along the electric line. Assuming evenly distributed capacitances, which may, however, not be the case in practice, then $q = 0.5$.

Following from equation Eq.1 the following four equations can be derived:

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) + real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0)) \qquad \text{Eq.2}$$

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) + imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0)) \qquad \text{Eq.3}$$

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) + real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0)) \qquad \text{Eq.4}$$

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) + imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0)) \qquad \text{Eq.5}$$

where

$\overline{U}_{ph\_t1}$ = phase-to-earth voltage of the faulted phase at the measuring point when the neutral to earth admittance of the electric network outside the electric line has the first value

$\overline{U}_{ph\_t2}$ = phase-to-earth voltage of the faulted phase at the measuring point when the neutral to earth admittance of the electric network outside the electric line has the second value

$\overline{U}_{0\_t1}$ = zero-sequence voltage of the electric network when the neutral to earth admittance of the electric network outside the electric line has the first value

$\overline{U}_{0\_t2}$ = zero-sequence voltage of the electric network when the neutral to earth admittance of the electric network outside the electric line has the second value

$\underline{I}_{0\_t1}$ = zero-sequence current of the electric line at the measuring point when the neutral to earth admittance of the electric network outside the electric line has the first value

$\overline{I}_{0\_t2}$ = zero-sequence current of the electric line at the measuring point when the neutral to earth admittance of the electric network outside the electric line has the second value

$\overline{I}_{1\_t1}$ = positive-sequence current of the electric line at the measuring point when the neutral to earth admittance of the electric network outside the electric line has the first value

$\overline{I}_{1\_t2}$ = positive-sequence current of the electric line at the measuring point when the neutral to earth admittance of the electric network outside the electric line has the second value

$\overline{I}_{2\_t1}$ = negative-sequence current of the electric line at the measuring point when the neutral to earth admittance of the electric network outside the electric line has the first value

$\overline{I}_{2\_t2}$ = negative-sequence current of the electric line at the measuring point when the neutral to earth admittance of the electric network outside the electric line has the second value.

Preferably the admittance $\overline{Y}_0 = G_0 + j*B_0$ is written in the following form:

$$\overline{Y}_0 = \boldsymbol{k}*B_0 + j*B_0$$

where k is the ratio of real part and imaginary part of $\overline{Y}_0$.

$$k = \frac{real(\overline{Y}_0)}{imag(\overline{Y}_0)} = \frac{k \cdot B_0}{B_0}$$

In practice the ratio **k** is typically in the range of 0.01...0.1.

If the following notations are used:

| | |
|---|---|
| $A = real(\overline{U}_{ph\_t1})$ | $N = real(\overline{U}_{ph\_t2})$ |
| $B = imag(\overline{U}_{ph\_t1})$ | $P = imag(\overline{U}_{ph\_t2})$ |
| $C = real(\overline{I}_{1\_t1})$ | $Q = real(\overline{I}_{1\_t2})$ |
| $E = imag(\overline{I}_{1\_t1})$ | $R = imag(\overline{I}_{1\_t2})$ |
| $F = real\overline{I}_{2\_t1})$ | $S = real(\overline{I}_{2\_t2})$ |
| $G = imag(\overline{I}_{2\_t1})$ | $T = imag(\overline{I}_{2\_t2})$ |
| $H = real(\overline{I}_{0\_t1})$ | $U = real(\overline{I}_{0\_t2})$ |
| $K = image(\overline{I}_{0\_t1})$ | $V = imag(\overline{I}_{0\_t2})$ |
| $L = real(\overline{U}_{0\_t1})$ | $W = real(\overline{U}_{0\_t2})$ |
| $M = imag(\overline{U}_{0\_t1})$ | $Z = imag(\overline{U}_{0\_t2})$ |

then fault distance d can be determined from the following equation obtained from equations Eq.2 to Eq.5:

```
d = -(-H*B*Z^2+K*A*W^2+K*A*Z^2-H*B*W^2-
U*M*W*A+U*M*Z*B+L*U*A*Z+L*P*H*W+L*V*B*Z-L*V*A*W-L*N*Z*H-L*N*W*K-
L*P*K*Z+L*U*B*W+N*M*W*H-U*M^2*P+N*V*M^2-L^2*P*U+L^2*N*V-N*M*Z*K-
M*Z*A*V-M*W*B*V+M*Z*H*P+M*W*K*P)/(E*R1*H*Z^2+R1*S*M*Z*K+X1*R*M*W*H-
R1*S*V*M^2-R1*S*M*W*H-M^2*R1*Q*V+M^2*X1*T*V+W^2*H^2*X0+X1*R*V*M^2-
X1*R*M*Z*K+2*X0*V*M*W*H-2*X0*V*M*Z*K-M*W*K*X1*Q-M*W*K*R1*T-
M*W*K*X1*S-
U*M*Z*X1*F+2*L*U*X0*Z*K+X0*V^2*M^2+X0*Z^2*H^2+X0*W^2*K^2+L^2*U^2*X0+L
^2*X0*V^2+U^2*M^2*X0-U*M*Z*R1*E-
U*M*W*X1*G+L*R1*Q*Z*H+L*R1*Q*W*K+L^2*U*X1*S+U*M*W*R1*F+U*M*W*R1*C-
U*M*Z*X1*C-U*M*W*X1*E-L*W*H*R1*R-L*W*H*X1*Q-L*W*H*R1*T-
2*L*U*X0*W*H+L*U*Z*X1*G-L*U*Z*R1*C-L*U*W*R1*E-L*U*W*X1*F-L*X1*T*Z*H-
L*X1*T*W*K-L*W*H*X1*S+L*R1*S*Z*H+L*R1*S*W*K-L*X1*R*Z*H-L*X1*R*W*K-
2*L*X0*V*Z*H-2*L*X0*V*W*K-L*W*X1*E*V+L^2*U*R1*T+L^2*X1*R*V-
L^2*R1*Q*V+L^2*U*X1*Q-
L^2*R1*S*V+L^2*X1*T*V+L^2*U*R1*R+U*M^2*R1*R+U*M^2*X1*Q+U*M^2*X1*S-
L*U*Z*R1*F+L*U*Z*X1*E-L*U*W*R1*G-
L*U*W*X1*C+L*Z*K*R1*R+L*Z*K*X1*Q+L*Z*K*R1*T+L*Z*K*X1*S-L*Z*R1*G*V-
L*Z*R1*E*V-L*Z*X1*F*V-L*Z*X1*C*V+L*W*R1*C*V-L*W*X1*G*V+L*W*R1*F*V-
M*Z*H*R1*R-2*M*Z*H*X0*U-M*Z*H*X1*Q-M*Z*H*R1*T-M*Z*H*X1*S-M*W*K*R1*R-
2*M*W*K*X0*U+M*W*X1*F*V-M*Z*X1*G*V+E*R1*H*W^2+H*F*X1*Z^2+U*M^2*R1*T-
F*R1*K*W^2-
C*R1*K*W^2+E*X1*K*W^2+G*X1*K*W^2+F*X1*H*W^2+G*R1*H*W^2+C*X1*H*W^2+G*X
1*K*Z^2+H*G*R1*Z^2-U*M*Z*R1*G-C*R1*K*Z^2+C*X1*H*Z^2+Z^2*K^2*X0-
R1*Q*M*W*H+R1*Q*M*Z*K+X1*T*M*W*H-X1*T*M*Z*K-
M*Z*X1*E*V+M*Z*R1*F*V+M*W*X1*C*V+M*Z*R1*C*V+M*W*R1*E*V+M*W*R1*G*V-
F*R1*K*Z^2+E*X1*K*Z^2)
```

According to an embodiment, also fault resistance $R_F$ is estimated and can be determined from the following equation obtained from equations Eq.2 to Eq.5:

```
RF = 1/3*(-R1*G*N*M*Z-M*Z*B*X1*R-M*Z*X1*F*N+M*Z*B*R1*S+Z*R1*F*M*P-
R1*E*N*M*Z-M*Z*B*X1*T-R0*M*Z*V*A+Z*R1*C*M*P+R0*M*Z*U*B-Z*A*M*X1*Q-
Z*A*M*R1*T-Z*A*M*X1*S-X0*Z*M*B*V-M*Z*X1*C*N+R0*M*H*P*Z-Z*A*M*R1*R-
X0*Z*N*M*H-X0*Z*U*M*A-M*X1*E*P*Z-Z*X1*G*M*P-W*B*M*R1*T-W*M*A*R1*Q-
W*M*X1*E*N-W*M*X1*G*N+W*R0*M*H*N-W*B*M*X1*S-W*M*A*R1*S+W*M*R1*F*N-
W*B*M*X1*Q-
W*R0*U*M*A+W*M*R1*C*N+W*R1*E*M*P+W*X1*C*M*P+W*R1*G*M*P+W*M*A*X1*T-
W*M*X0*U*B+W*M*A*X1*R+W*M*X0*P*H+W*M*X0*V*A-W*R0*M*B*V-
W*B*M*R1*R+W*X1*F*M*P+L*R0*V*B*Z-L*R1*G*P*Z-L*Z*A*X1*T-
L*X1*F*P*Z+L*Z*A*R1*S-L*R1*E*P*Z+L*Z*X1*G*N-L*Z*R1*C*N-L*Z*A*X1*R-
L*X1*C*P*Z+L*B*Z*R1*R-L*X0*Z*V*A-L*W*X1*S*A-L*W*B*X0*V-L*W*X0*H*N-
L*W*B*X1*R+L*W*B*R1*Q-L*W*B*X1*T-L*W*R1*G*N+L*Z*A*R1*Q+L*W*R0*P*H-
L*W*X1*Q*A-L*W*X0*U*A+L*W*R0*U*B-L*W*X1*F*N-L*W*R0*V*A+L*W*P*F*R1-
L*W*P*E*X1-L*W*X1*C*N-L*W*R1*E*N+L*W*P*C*R1-
L*W*P*G*X1+L*Z*X1*E*N+L*X0*Z*U*B-L*X0*Z*P*H+L*R0*U*A*Z-L*Z*R1*F*N-
L*W*R1*R*A+L*B*Z*X1*S+L*B*Z*R1*T+L*B*Z*X1*Q-L*R0*Z*H*N+L*W*B*R1*S-
L*W*R1*T*A+K*B*Z^2*X0+K*R0*A*Z^2+K*W^2*A*R0+K*W^2*B*X0+X1*F*A*Z^2+R1*
G*A*Z^2+M^2*X0*U*N-M^2*P*R1*Q-
R0*U*M^2*P+M^2*P*X1*R+M^2*P*X1*T+M^2*P*X0*V-
M^2*P*R1*S+W^2*R1*G*A+W^2*R1*E*A+W^2*X1*F*A+W^2*X1*C*A-
W^2*B*F*R1+R1*E*A*Z^2-K*R0*M*Z*N-
B*C*R1*Z^2+M^2*R1*T*N+X1*C*A*Z^2+M*Z*B*R1*Q+B*G*X1*Z^2+X0*H*A*Z^2+R0*
V*M^2*N-W^2*B*C*R1-L^2*R0*P*U-R0*H*B*Z^2+M^2*X1*Q*N+M^2*X1*S*N-
B*F*R1*Z^2-K*L*W*N*R0-K*L*W*P*X0+B*E*X1*Z^2+M^2*R1*R*N-
K*L*R0*P*Z+K*L*X0*Z*N-K*W*M*X0*N+K*W*R0*M*P-K*X0*Z*M*P+W^2*B*E*X1-
W^2*R0*H*B+W^2*B*G*X1+W^2*X0*H*A+L^2*X1*Q*N+L^2*X1*S*N+L^2*X0*U*N+L^2
*P*X1*R+L^2*R1*R*N+L^2*P*X0*V-L^2*P*R1*Q+L^2*P*X1*T-
L^2*P*R1*S+L^2*R1*T*N+L^2*R0*V*N)/(E*R1*H*Z^2+R1*S*M*Z*K+X1*R*M*W*H-
R1*S*V*M^2-R1*S*M*W*H-M^2*R1*Q*V+M^2*X1*T*V+W^2*H^2*X0+X1*R*V*M^2-
X1*R*M*Z*K+2*X0*V*M*W*H-2*X0*V*M*Z*K-M*W*K*X1*Q-M*W*K*R1*T-
M*W*K*X1*S-
U*M*Z*X1*F+2*L*U*X0*Z*K+X0*V^2*M^2+X0*Z^2*H^2+X0*W^2*K^2+L^2*U^2*X0+L
^2*X0*V^2+U^2*M^2*X0-U*M*Z*R1*E-
U*M*W*X1*G+L*R1*Q*Z*H+L*R1*Q*W*K+L^2*U*X1*S+U*M*W*R1*F+U*M*W*R1*C-
U*M*Z*X1*C-U*M*W*X1*E-L*W*H*R1*R-L*W*H*X1*Q-L*W*H*R1*T-
2*L*U*X0*W*H+L*U*Z*X1*G-L*U*Z*R1*C-L*U*W*R1*E-L*U*W*X1*F-L*X1*T*Z*H-
L*X1*T*W*K-L*W*H*X1*S+L*R1*S*Z*H+L*R1*S*W*K-L*X1*R*Z*H-L*X1*R*W*K-
2*L*X0*V*Z*H-2*L*X0*V*W*K-L*W*X1*E*V+L^2*U*R1*T+L^2*X1*R*V-
L^2*R1*Q*V+L^2*U*X1*Q-
L^2*R1*S*V+L^2*X1*T*V+L^2*U*R1*R+U*M^2*R1*R+U*M^2*X1*Q+U*M^2*X1*S-
L*U*Z*R1*F+L*U*Z*X1*E-L*U*W*R1*G-
L*U*W*X1*C+L*Z*K*R1*R+L*Z*K*X1*Q+L*Z*K*R1*T+L*Z*K*X1*S-L*Z*R1*G*V-
L*Z*R1*E*V-L*Z*X1*F*V-L*Z*X1*C*V+L*W*R1*C*V-L*W*X1*G*V+L*W*R1*F*V-
M*Z*H*R1*R-2*M*Z*H*X0*U-M*Z*H*X1*Q-M*Z*H*R1*T-M*Z*H*X1*S-M*W*K*R1*R-
2*M*W*K*X0*U+M*W*X1*F*V-M*Z*X1*G*V+E*R1*H*W^2+H*F*X1*Z^2+U*M^2*R1*T-
F*R1*K*W^2-
C*R1*K*W^2+E*X1*K*W^2+G*X1*K*W^2+F*X1*H*W^2+G*R1*H*W^2+C*X1*H*W^2+G*X
1*K*Z^2+H*G*R1*Z^2-U*M*Z*R1*G-C*R1*K*Z^2+C*X1*H*Z^2+Z^2*K^2*X0-
R1*Q*M*W*H+R1*Q*M*Z*K+X1*T*M*W*H-X1*T*M*Z*K-
M*Z*X1*E*V+M*Z*R1*F*V+M*W*X1*C*V+M*Z*R1*C*V+M*W*R1*E*V+M*W*R1*G*V-
F*R1*K*Z^2+E*X1*K*Z^2)
```

An advantage of the method and arrangement of the invention is that they enable the fault distance estimation without parameter $Y_0$ consisting of conductance $G_0$ and susceptance $B_0$, although its influence is still included in the fault distance estimation.

Further, the method and arrangement of the invention eliminates the requirement to approximate how the phase-to-earth admittance of the electric line $\overline{Y}_0$ is distributed along the electric line (setting parameter $q$), which can be considered as another major benefit.

Further, the method and arrangement of the invention enables an estimation of the phase-to-earth admittance of the electric line $\overline{Y}_0$ together with fault distance and fault resistance by solving $\textbf{\textit{k}}$ (the ratio of real part and imaginary part of $\overline{Y}_0$) and susceptance $B_0$ from equations Eq.2 to Eq.5 in a similar manner.

The method and arrangement of the invention enables accurate fault location with fewer settings in e.g. compensated networks at fault resistance values in the range of a few hundred ohms.

An apparatus according to any one of the above embodiments, or a combination thereof, may be implemented as a single unit or as two or more separate units that are configured to implement the functionality of the various embodiments. Here the term 'unit' refers generally to a physical or logical entity, such as a physical device or a part thereof or a software routine. One or more of these units may reside in the protective relay unit 40, for example.

An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of the microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, which input means thus enable e.g. the monitoring of current and voltage quantities, and output means for outputting e.g. calculation results and/or control data. It is also possible to use a specific integrated circuit or circuits, or corresponding components and devices for implementing the functionality according to any one of the embodiments.

The invention can be implemented in existing system elements, such as various protective relays, relay arrangements or generally IEDs (Intelligent Electronic Device), or by using separate dedicated elements or devices in a centralized or distributed manner. Present protective devices for electric systems, such as protective relays, and IEDs typically comprise processors and memory that can be utilized in the functions according to embodiments of the invention. Thus, all modifications and configurations required for implementing an embodiment of the invention e.g. in existing devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory means, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

**Claims**

**1.** A method for determining a distance to a phase-to-earth fault on a three-phase electric line of an electric network, the method comprising:

determining, during a phase-to-earth fault (F) on the three-phase electric line (30), a value of a zero-sequence voltage of the electric network and values of a phase-to-earth voltage of a faulted phase, a zero-sequence current, a positive-sequence current and a negative-sequence current of the three-phase electric line at a measuring point, when a neutral to earth admittance of the electric network outside the three-phase electric line (30) has a first value;

determining, during the phase-to-earth fault (F) on the three-phase electric line (30), a value of the zero-sequence voltage of the electric network and values of the phase-to-earth voltage of the faulted phase, the zero-sequence current, the positive-sequence current and the negative-sequence current of the three-phase electric line at the measuring point, when the neutral to earth admittance of the electric network outside the three-phase electric line (30) has a second value different from the first value; and

determining the distance to the phase-to-earth fault (F) from the measuring point (40) on the basis of the determined current and voltage values, **characterized in that** the distance is determined by using four equations derivable from an equivalent circuit for a phase-to-earth fault on a three-phase electric line, wherein

the first equation relates a real part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the first value;

the second equation relates an imaginary part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the first value;

the third equation relates the real part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the second value; and

the fourth equation relates the imaginary part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the second value.

2. A method as claimed in claim 1, **characterized in that** the first equation is:

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) +$$
$$real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0))$$

the second equation is:

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) +$$
$$imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0))$$

the third equation is:

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) +$$
$$real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0))$$

and the fourth equation is:

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) +$$
$$imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0))$$

where

$\overline{U}_{ph\_t1}$ = phase-to-earth voltage of the faulted phase at the measuring point when the neutral to earth admittance of the electric network outside the three-phase electric line has the first value

$\overline{U}_{ph\_t2}$ = phase-to-earth voltage of the faulted phase at the measuring point when the neutral to earth admittance of the electric network outside the three-phase electric line has the second value

$d$ = fault distance between the measuring point and the fault location

$\overline{Z}_0$ = zero-sequence impedance of the three-phase electric line

$\overline{Z}_1$ = positive-sequence impedance of the three-phase electric line

$\overline{Z}_2$ = negative-sequence impedance of the three-phase electric line

$R_F$ = fault resistance

$\overline{Y}_0$ = phase-to-earth admittance of the three-phase electric line per phase

$\overline{U}_{0\_t1}$ = zero-sequence voltage of the electric network when the neutral to earth admittance of the electric network outside the three-phase electric line has the first value

$\overline{U}_{0\_t2}$ = zero-sequence voltage of the electric network when the neutral to earth admittance of the electric network outside the three-phase electric line has the second value

$\overline{I}_{0\_t1}$ = zero-sequence current of the three-phase electric line at the measuring point when the neutral to earth admittance of the electric network outside the three-phase electric line has the first value

$\overline{I}_{0\_t2}$ = zero-sequence current of the three-phase electric line at the measuring point when the neutral to earth admittance of the electric network outside the three-phase electric line has the second value

$\overline{I}_{1\_t1}$ = positive-sequence current of the three-phase electric line at the measuring point when the neutral to earth admittance of the electric network outside the three-phase electric line has the first value

$\overline{I}_{1\_t2}$ = positive-sequence current of the three-phase electric line at the measuring point when the neutral to earth admittance of the electric network outside the three-phase electric line has the second value

$\overline{I}_{2\_t1}$ = negative-sequence current of the three-phase electric line at the measuring point when the neutral to earth admittance of the electric network outside the three-phase electric line has the first value

$\overline{I}_{2\_t2}$ = negative-sequence current of the three-phase electric line at the measuring point when the neutral to earth admittance of the electric network outside the three-phase electric line has the second value

$q$ = distribution factor for the zero-sequence current of the three-phase electric line.

3. A method as claimed in claim 1 or 2, **characterized by** changing the neutral to earth admittance of the electric network outside the three-phase electric line (30) from the first value to the second value by connecting or disconnecting a parallel resistor of a compensation coil or by changing a compensation degree of the compensation coil.

4. A method as claimed in claim 1, 2 or 3, **characterized by** determining the fault resistance using said four equations corresponding to the equivalent circuit for the phase-to-earth fault on a three-phase electric line.

5. A computer program product comprising computer program code, wherein execution of the program code in a computer causes the computer to carry out the steps of the method according to any one of claims 1 to 4.

6. An apparatus for determining a distance to a phase-to-earth fault on a three-phase electric line of an electric network, the apparatus comprising:

means (40) adapted to determine, during a phase-to-earth fault (F) on the three-phase electric line (30), a value of a zero-sequence voltage of the electric network and values of a phase-to-earth voltage of a faulted phase, a zero-sequence current, a positive-sequence current and a negative-sequence current of the three-phase electric line at a measuring point, when a neutral to earth admittance of the electric network outside the three-phase electric line (30) has a first value;
means (40) adapted to determine, during the phase-to-earth fault (F) on the three-phase electric line (30), a value of the zero-sequence voltage of the electric network and values of the phase-to-earth voltage of the faulted phase, the zero-sequence current, the positive-sequence current and the negative-sequence current of the three-phase electric line at the measuring point, when the neutral to earth admittance of the electric network outside the three-phase electric line (30) has a second value different from the first value; and
means (40) adapted to determine the distance to the phase-to-earth fault (F) from the measuring point (40) on the basis of the determined current and voltage values, **characterized in that** the means (40) adapted to determine the distance are configured to use four equations derivable from an equivalent circuit for a phase-to-earth fault on a three-phase electric line for the determination of the distance to the phase-to-earth fault (F) from the measuring point (40) such that
the first equation relates a real part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the first value; the second equation relates an imaginary part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the first value;

the third equation relates the real part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the second value; and

the fourth equation relates the imaginary part of the phase-to-earth voltage of the faulted phase at the measuring point to the zero-sequence voltage of the electric network and to the zero-sequence current, the positive-sequence current and the negative-sequence current of the three-phase electric line at the measuring point, when the neutral to earth admittance of the electric network outside the three-phase electric line (30) has the second value.

7. An apparatus as claimed in claim 6, **characterized in that** the first equation is:

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) + real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0))$$

the second equation is:

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) + imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0))$$

the third equation is:

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) + real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0))$$

and the fourth equation is:

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) + imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0))$$

where

$\overline{U}_{ph\_t1}$ = phase-to-earth voltage of the faulted phase at the measuring point when the neutral to earth admittance of the electric network outside the three-phase electric line has the first value

$\overline{U}_{Ph\_t2}$ = phase-to-earth voltage of the faulted phase at the measuring point when the neutral to earth admittance of the electric network outside the three-phase electric line has the second value

$d$ = fault distance between the measuring point and the fault location

$\overline{Z}_0$ = zero-sequence impedance of the three-phase electric line

$\overline{Z}_1$ = positive-sequence impedance of the three-phase electric line

$\overline{Z}_2$ = negative-sequence impedance of the three-phase electric line

$R_F$ = fault resistance

$\overline{Y}_0$ = phase-to-earth admittance of the three-phase electric line per phase

$\overline{U}_{0\_t1}$ = zero-sequence voltage of the electric network when the neutral to earth admittance of the electric network outside the three-phase electric line has the first value

$\overline{U}_{0\_t2}$ = zero-sequence voltage of the electric network when the neutral to earth admittance of the electric network outside the three-phase electric line has the second value

$\overline{I}_{0\_t1}$ = zero-sequence current of the three-phase electric line at the measuring point when the neutral to earth admittance of the electric network outside the three-phase electric line has the first value

$\overline{I}_{0\_t2}$ = zero-sequence current of the three-phase electric line at the measuring point when the neutral to earth admittance of the electric network outside the three-phase electric line has the second value

$\overline{I}_{1\_t1}$ = positive-sequence current of the three-phase electric line at the measuring point when the neutral to earth admittance of the electric network outside the three-phase electric line has the first value

$\overline{I}_{1\_t2}$ = positive-sequence current of the three-phase electric line at the measuring point when the neutral to earth admittance of the electric network outside the three-phase electric line has the second value

$\overline{I}_{2\_t1}$ = negative-sequence current of the three-phase electric line at the measuring point when the neutral to earth admittance of the electric network outside the three-phase electric line has the first value

$\overline{I}_{2\_t2}$ = negative-sequence current of the three-phase electric line at the measuring point when the neutral to earth admittance of the electric network outside the three-phase electric line has the second value

$q$ = distribution factor for the zero-sequence current of the three-phase electric line.

8. An apparatus as claimed in claim 6 or 7, **characterized in that** the apparatus comprises means adapted to change the neutral to earth admittance of the electric network outside the three-phase electric line (30) from the first value to the second value by connecting or disconnecting a parallel resistor of a compensation coil or by changing a compensation degree of the compensation coil.

9. An apparatus as claimed in claim 6, 7 or 8, **characterized in that** the apparatus comprises means (40) adapted to determine the fault resistance by using said four equations corresponding to the equivalent circuit for the phase-to-earth fault on a three-phase electric line.

10. An apparatus as claimed in any one of claims 6 to 9, **characterized in that** the apparatus comprises a protective relay.


**Patentansprüche**

1. Verfahren zum Bestimmen einer Distanz zu einem Phase-Erde-Fehler an einer dreiphasigen elektrischen Leitung eines elektrischen Netzes, wobei das Verfahren umfasst:

während eines Phase-Erde-Fehlers (F) an der dreiphasigen elektrischen Leitung (30), Bestimmen eines Werts einer Nullsequenz-Spannung des elektrischen Netzes und von Werten einer Phase-Erde-Spannung einer fehlerbehafteten Phase, eines Null-Sequenz-Stroms, eines Positiv-Sequenz-Stroms und eines Negativ-Sequenz-Stroms der dreiphasigen elektrischen Leitung an einem Messpunkt, wenn eine Neutral-Erde-Admittanz des elektrischen Netzwerks außerhalb der dreiphasigen elektrischen Leitung (30) einen ersten Wert hat;

während des Phase-Erde-Fehlers (F) an der dreiphasigen elektrischen Leitung (30), Bestimmen eines Werts der Nullsequenz-Spannung des elektrischen Netzes und von Werten einer Phase-Erde-Spannung der fehlerbehafteten Phase, des Null-Sequenz-Stroms, des Positiv-Sequenz-Stroms und des Negativ-Sequenz-Stroms der dreiphasigen elektrischen Leitung an dem Messpunkt, wenn die Neutral-Erde-Admittanz des elektrischen Netzwerks außerhalb der dreiphasigen elektrischen Leitung (30) einen zweiten Wert hat, der sich von dem ersten Wert unterscheidet; und

Bestimmen der Distanz des Phase-Erde-Fehlers (F) von dem Messpunkt (40) auf der Basis der bestimmten Strom- und Spannungswerte, **dadurch gekennzeichnet, dass** die Distanz unter Verwendung von vier Gleichungen bestimmt wird, die aus einer Äquivalenzschaltung für einen Phase-Erde-Fehler an einer dreiphasigen elektrischen Leitung ableitbar sind, wobei

die erste Gleichung einen realen Teil der Phase-Erde-Spannung der fehlerbehafteten Phase an dem Messpunkt in Beziehung zu der Nullsequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den ersten Wert hat;

die zweite Gleichung einen imaginären Teil der Phase-Erde-Spannung der fehlerbehafteten Phase an dem Messpunkt in Beziehung zu der Nullsequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den ersten Wert hat;

die dritte Gleichung einen realen Teil der Phase-Erde-Spannung der fehlerbehafteten Phase an dem Messpunkt in Beziehung zu der Nullsequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den zweiten Wert hat; und

die vierte Gleichung den imaginären Teil der Phase-Erde-Spannung der fehlerbehafteten Phase an dem Messpunkt in Beziehung zu der Null-sequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den zweiten Wert hat.

2. Verfahren nach Anspruch 1, **dadurch gekennzeichnet, dass** die erste Gleichung lautet:

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) +$$
$$real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0))$$

die zweite Gleichung lautet:

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) +$$
$$imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0))$$

die dritte Gleichung lautet:

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) +$$
$$real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0))$$

und die vierte Gleichung lautet:

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) +$$
$$imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0))$$

wobei

$\overline{U}_{ph\_t1}$ = Phase-Erde-Spannung der fehlerbehafteten Phase an dem Messpunkt, wenn die Neutral-Erde-Admittanz des elektrischen Netzwerks außerhalb der dreiphasigen elektrischen Leitung den ersten Wert hat,

$\overline{U}_{ph\_t2}$ = Phase-Erde-Spannung der fehlerbehafteten Phase an dem Messpunkt, wenn die Neutral-Erde-Admittanz des elektrischen Netzwerks außerhalb der dreiphasigen elektrischen Leitung den zweiten Wert hat,

$d$ = Fehler-Distanz zwischen dem Messpunkt und der Fehler-Stelle,

$\overline{Z}_0$ = Null-Sequenz-Impedanz der dreiphasigen elektrischen Leitung,

$\overline{Z}_1$ = Positiv-Sequenz-Impedanz der dreiphasigen elektrischen Leitung,

$\overline{Z}_2$ = Negativ-Sequenz-Impedanz der dreiphasigen elektrischen Leitung,

$R_F$ = Fehlerresistenz

$\overline{Y}_0$ = Phase-Erde-Admittanz der dreiphasigen elektrischen Leitung pro Phase,

$\overline{U}_{0\_t1}$ Null-Sequenz-Spannung des elektrischen Netzwerks, wenn die Neutral-Erde-Admittanz des elektrischen Netzwerks außerhalb der dreiphasigen elektrischen Leitung den ersten Wert hat,
$\overline{U}_{0\_t2}$ = Null-Sequenz-Spannung des elektrischen Netzwerks, wenn die Neutral-Erde-Admittanz des elektrischen Netzwerks außerhalb der dreiphasigen elektrischen Leitung den zweiten Wert hat,
$\overline{I}_{0\_t1}$ = Null-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den ersten Wert hat,
$\overline{I}_{0\_t2}$ = Null-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den zweiten Wert hat,
$\overline{I}_{1\_t1}$ = Positiv-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den ersten Wert hat,
$\overline{I}_{1\_t2}$ = Positiv-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den zweiten Wert hat,
$\overline{I}_{1\_t1}$ = Negativ-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den ersten Wert hat,
$\overline{I}_{2\_t2}$ = Negativ-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den zweiten Wert hat,
$q$ = Verteilungsfaktor für den Null-Sequenz-Strom der dreiphasigen elektrischen Leitung.

3. Verfahren nach Anspruch 1 oder 2, **gekennzeichnet durch** Ändern der Neutral-Erde-Admittanz des elektrischen Netzwerks außerhalb der dreiphasigen elektrischen Leitung (30) von dem ersten Wert zu dem zweiten Wert **durch** Anschließen oder Abtrennen eines Parallelwiderstands einer Kompensationswicklung oder **durch** Ändern eines Kompensationsgrads der Kompensationswicklung.

4. Verfahren nach Anspruch 1, 2 oder 3, **gekennzeichnet durch** Bestimmen der Fehlerresistenz unter Verwendung der genannten vier Gleichungen, die der Äquivalenzschaltung für den Phase-Erde-Fehler an einer dreiphasigen elektrischen Leitung entsprechen.

5. Computerprogrammprodukt mit einem Computerprogrammcode, bei dem die Ausführung des Programmcodes in einem Computer den Computer zur Ausführung der Schritte des Verfahrens nach einem der Ansprüche 1 bis 4 veranlasst.

6. Vorrichtung zum Bestimmen einer Distanz zu einem Phase-Erde-Fehler an einer dreiphasigen elektrischen Leitung eines elektrischen Netzes, wobei die Vorrichtung aufweist:

Einrichtungen (40), die in der Lage sind, während eines Phase-Erde-Fehlers (F) an der dreiphasigen elektrischen Leitung (30) einen Wert einer Nullsequenz-Spannung des elektrischen Netzes und Werte einer Phase-Erde-Spannung einer fehlerbehafteten Phase, eines Null-Sequenz-Stroms, eines Positiv-Sequenz-Stroms und eines Negativ-Sequenz-Stroms der dreiphasigen elektrischen Leitung an einem Messpunkt zu bestimmen, wenn eine Neutral-Erde-Admittanz des elektrischen Netzwerks außerhalb der dreiphasigen elektrischen Leitung (30) einen ersten Wert hat;
Einrichtungen (40), die in der Lage sind, während des Phase-Erde-Fehlers (F) an der dreiphasigen elektrischen Leitung (30) einen Wert der Nullsequenz-Spannung des elektrischen Netzes und Werte einer Phase-Erde-Spannung der fehlerbehafteten Phase, des Null-Sequenz-Stroms, des Positiv-Sequenz-Stroms und des Negativ-Sequenz-Stroms der dreiphasigen elektrischen Leitung an dem Messpunkt zu bestimmen, wenn die Neutral-Erde-Admittanz des elektrischen Netzwerks außerhalb der dreiphasigen elektrischen Leitung (30) einen zweiten Wert hat, der sich von dem ersten Wert unterscheidet; und Einrichtungen (40), die in der Lage sind, die Distanz zu dem Phase-Erde-Fehler (F) von dem Messpunkt (40) auf der Basis der bestimmten Strom- und Spannungswerte zu bestimmen, **dadurch gekennzeichnet, dass** die Einrichtungen (40), die zum Bestimmen der Distanz in der Lage sind, zur Verwendung von vier Gleichungen, welche aus einer Äquivalenzschaltung für einen Phase-Erde-Fehler an einer dreiphasigen elektrischen Leitung ableitbar sind, konfiguriert sind, um die Distanz zu dem Phase-Erde-Fehler (F) von dem Messpunkt (40) zu bestimmen, derart, dass die erste Gleichung einen realen Teil der Phase-Erde-Spannung der fehlerbehafteten Phase an dem Messpunkt in Beziehung zu der Nullsequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den ersten Wert hat;

die zweite Gleichung einen imaginären Teil der Phase-Erde-Spannung der fehlerbehafteten Phase an dem Messpunkt in Beziehung zu der Nullsequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den ersten Wert hat;

die dritte Gleichung einen realen Teil der Phase-Erde-Spannung der fehlerbehafteten Phase an dem Messpunkt in Beziehung zu der Nullsequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den zweiten Wert hat; und

die vierte Gleichung den imaginären Teil der Phase-Erde-Spannung der fehlerbehafteten Phase an dem Messpunkt in Beziehung zu der Null-sequenz-Spannung des elektrischen Netzwerks und zu dem Null-Sequenz-Strom, dem Positiv-Sequenz-Strom und dem Negativ-Sequenz-Strom der dreiphasigen elektrischen Leitung an dem Messpunkt setzt, wenn die Neutral-Erde-Admittanz des elektrischen Netzwerks außerhalb der dreiphasigen elektrischen Leitung (30) den zweiten Wert hat.

7. Verfahren nach Anspruch 6, **dadurch gekennzeichnet, dass** die erste Gleichung lautet:

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) +$$
$$real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0))$$

die zweite Gleichung lautet:

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) +$$
$$imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0))$$

die dritte Gleichung lautet:

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) +$$
$$real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0))$$

und die vierte Gleichung lautet:

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) +$$
$$imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0))$$

wobei

$\overline{U}_{ph\_t1}$ = Phase-Erde-Spannung der fehlerbehafteten Phase an dem Messpunkt, wenn die Neutral-Erde-Admittanz des elektrischen Netzwerks außerhalb der dreiphasigen elektrischen Leitung den ersten Wert hat,

$\overline{U}_{ph\_t2}$ = Phase-Erde-Spannung der fehlerbehafteten Phase an dem Messpunkt, wenn die Neutral-Erde-Admittanz des elektrischen Netzwerks außerhalb der dreiphasigen elektrischen Leitung den zweiten Wert hat,

$d$ = Fehler-Distanz zwischen dem Messpunkt und der Fehler-Stelle,

$\overline{Z}_0$ = Null-Sequenz-Impedanz der dreiphasigen elektrischen Leitung,

$\overline{Z}_1$ = Positiv-Sequenz-Impedanz der dreiphasigen elektrischen Leitung,

$\overline{Z}_2$ = Negativ-Sequenz-Impedanz der dreiphasigen elektrischen Leitung,

$R_F$ = Fehlerresistenz

$\overline{Y}_0$ = Phase-Erde-Admittanz der dreiphasigen elektrischen Leitung pro Phase,

$\overline{U}_{0\_t1}$ Null-Sequenz-Spannung des elektrischen Netzwerks, wenn die Neutral-Erde-Admittanz des elektrischen Netzwerks außerhalb der dreiphasigen elektrischen Leitung den ersten Wert hat,

$\overline{U}_{0\_t2}$ = Null-Sequenz-Spannung des elektrischen Netzwerks, wenn die Neutral-Erde-Admittanz des elektrischen Netzwerks außerhalb der dreiphasigen elektrischen Leitung den zweiten Wert hat,

$\overline{I}_{0\_t1}$ = Null-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den ersten Wert hat,

$\overline{I}_{0\_t2}$ = Null-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den zweiten Wert hat,

$\overline{I}_{1\_t1}$ = Positiv-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den ersten Wert hat,

$\overline{I}_{1\_t2}$ = Positiv-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den zweiten Wert hat,

$\overline{I}_{2\_t1}$ = Negativ-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den ersten Wert hat,

$\overline{I}_{2\_t2}$ = Negativ-Sequenz-Strom der dreiphasigen elektrischen Leitung an dem Messpunkt, wenn die Neutral-Erde-Admittanz des elektrischen Netzwerks außerhalb der dreiphasigen elektrischen Leitung den zweiten Wert hat,

$q$ = Verteilungsfaktor für den Null-Sequenz-Strom der dreiphasigen elektrischen Leitung.

8. Vorrichtung nach Anspruch 6 oder 7, **dadurch gekennzeichnet, dass** die Vorrichtung Einrichtungen aufweist, die in der Lage sind, die Neutral-Erde-Admittanz des elektrischen Netzwerks außerhalb der dreiphasigen elektrischen Leitung (30) von dem ersten Wert zu dem zweiten Wert zu ändern, indem sie einen Parallelwiderstand einer Kompensationswicklung anschließen oder abtrennen oder einen Kompensationsgrad der Kompensationswicklung ändern.

9. Vorrichtung nach Anspruch 6, 7 oder 8, **dadurch gekennzeichnet, dass** die Vorrichtung Einrichtungen (40) aufweist, die in der Lage sind, die Fehlerresistenz unter Verwendung der genannten vier Gleichungen, die der Äquivalenzschaltung für den Phase-Erde-Fehler an einer dreiphasigen elektrischen Leitung entsprechen, zu bestimmen.

10. Vorrichtung nach einem der Ansprüche 6 bis 9, **dadurch gekennzeichnet, dass** die Vorrichtung ein Schutzrelais aufweist.

**Revendications**

1. Procédé de détermination d'une distance à un défaut entre phase et terre sur une ligne électrique triphasée d'un réseau électrique, le procédé comprenant :

la détermination, au cours d'un défaut entre phase et terre (F) sur la ligne électrique triphasée (30), d'une valeur d'une tension homopolaire du réseau électrique et de valeurs d'une tension phase-terre d'une phase en défaut, d'un courant homopolaire, d'un courant de séquence positive et d'un courant de séquence négative de la ligne électrique triphasée à un point de mesure, lorsqu'une admittance du neutre à la terre du réseau électrique à l'extérieur de la ligne électrique triphasée (30) a une première valeur ;

la détermination, au cours du défaut entre phase et terre (F) sur la ligne électrique triphasée (30), d'une valeur de la tension homopolaire du réseau électrique et de valeurs de la tension phase-terre d'une phase en défaut, du courant homopolaire, du courant de séquence positive et du courant de séquence négative de la ligne électrique triphasée au point de mesure, lorsque l'admittance du neutre à la terre du réseau électrique à l'extérieur de la ligne électrique triphasée (30) a une deuxième valeur différente de la première valeur ; et

la détermination de la distance au défaut entre phase et terre (F) à partir du point de mesure (40) sur la base des valeurs de courant et de tension déterminées, **caractérisé en ce que** la distance est déterminée en utilisant quatre équations dérivables d'un circuit équivalent pour un défaut entre phase et terre sur une ligne électrique triphasée, dans lequel

la première équation met en relation une partie réelle de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la première valeur ;

la deuxième équation met en relation une partie imaginaire de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la première valeur ;

la troisième équation met en relation la partie réelle de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la deuxième valeur ; et

la quatrième équation met en relation la partie imaginaire de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la deuxième valeur.

2. Procédé selon la revendication 1, **caractérisé en ce que** la première équation est :

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) + real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0))$$

la deuxième équation est :

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) + imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0))$$

la troisième équation est :

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) + real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0))$$

et la quatrième équation est :

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) + imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0))$$

où

$\overline{U}_{ph\text{-}t1}$ = tension phase-terre de la phase en défaut au point de mesure lorsque l'admittance du neutre à la terre du réseau électrique à l'extérieur de la ligne électrique triphasée a la première valeur ;

$\overline{U}_{ph\text{-}t2}$ = tension phase-terre de la phase en défaut au point de mesure lorsque l'admittance du neutre à la terre du réseau électrique à l'extérieur de la ligne électrique triphasée a la deuxième valeur ;

d = distance de défaut entre le point de mesure et l'emplacement de défaut ;

$\overline{Z}_0$ = impédance homopolaire de la ligne électrique triphasée ;

$\overline{Z}_1$ = impédance de séquence positive de la ligne électrique triphasée ;

$\overline{Z}_2$ = impédance de séquence négative de la ligne électrique triphasée ;

$R_F$ = résistance de défaut ;

$\overline{Y}_0$ = admittance de phase à terre de la ligne électrique triphasée par phase ;

$\overline{U}_{0\text{-}t1}$ = tension homopolaire du réseau électrique lorsque l'admittance du neutre à la terre du réseau électrique à l'extérieur de la ligne électrique triphasée a la première valeur ;

$\overline{U}_{0\text{-}t2}$ = tension homopolaire du réseau électrique lorsque l'admittance du neutre à la terre du réseau électrique à l'extérieur de la ligne électrique triphasée a la deuxième valeur ;

$\overline{I}_{0\text{-}t1}$ = courant homopolaire de la ligne électrique triphasée au point de mesure lorsque l'admittance du neutre à la terre du réseau électrique à l'extérieur de la ligne électrique triphasée a la première valeur ;

$\overline{I}_{0\text{-}t2}$ = courant homopolaire de la ligne électrique triphasée au point de mesure lorsque l'admittance du neutre à la terre du réseau électrique à l'extérieur de la ligne électrique triphasée a la deuxième valeur ;

$\overline{I}_{1\text{-}t1}$ = courant de séquence positive de la ligne électrique triphasée au point de mesure lorsque l'admittance du neutre à la terre du réseau électrique à l'extérieur de la ligne électrique triphasée a la première valeur ;

$\overline{I}_{1\text{-}t2}$ = courant de séquence positive de la ligne électrique triphasée au point de mesure lorsque l'admittance du neutre à la terre du réseau électrique à l'extérieur de la ligne électrique triphasée a la deuxième valeur ;

$\overline{I}_{2\text{-}t1}$ = courant de séquence négative de la ligne électrique triphasée au point de mesure lorsque l'admittance du neutre à la terre du réseau électrique à l'extérieur de la ligne électrique triphasée a la première valeur ;

$\overline{I}_{2\text{-}t2}$ = courant de séquence négative de la ligne électrique triphasée au point de mesure lorsque l'admittance du neutre à la terre du réseau électrique à l'extérieur de la ligne électrique triphasée a la deuxième valeur ;

q = facteur de distribution du courant homopolaire de la ligne électrique triphasée.

3. Procédé selon la revendication 1 ou 2, **caractérisé par** le changement de l'admittance du neutre à la terre du réseau électrique à l'extérieur de la ligne électrique triphasée (30) de la première valeur à la deuxième valeur en connectant ou en déconnectant une résistance parallèle d'une bobine de compensation ou en changeant un degré de compensation de la bobine de compensation.

4. Procédé selon la revendication 1, 2 ou 3, **caractérisé par** la détermination de la résistance de défaut en utilisant lesdites quatre équations correspondant au circuit équivalent pour le défaut de phase à terre sur une ligne électrique triphasée.

5. Produit de programme informatique comprenant un code de programme informatique, dans lequel une exécution du code de programme dans un ordinateur amène l'ordinateur à effectuer les étapes du procédé selon l'une quelconque des revendications 1 à 4.

6. Appareil de détermination d'une distance à un défaut entre phase et terre sur une ligne électrique triphasée d'un réseau électrique, l'appareil comprenant :

un moyen (40) apte à effectuer la détermination, au cours d'un défaut entre phase et terre (F) sur la ligne électrique triphasée (30), d'une valeur d'une tension homopolaire du réseau électrique et de valeurs d'une tension phase-terre d'une phase en défaut, d'un courant homopolaire, d'un courant de séquence positive et d'un courant de séquence négative de la ligne électrique triphasée à un point de mesure, lorsqu'une admittance du neutre à la terre du réseau électrique à l'extérieur de la ligne électrique triphasée (30) a une première valeur ;

un moyen (40) apte à effectuer la détermination, au cours du défaut entre phase et terre (F) sur la ligne électrique triphasée (30), d'une valeur de la tension homopolaire du réseau électrique et de valeurs de la tension phase-terre d'une phase en défaut, du courant homopolaire, du courant de séquence positive et du courant de séquence négative de la ligne électrique triphasée au point de mesure, lorsque l'admittance du neutre à la terre du réseau électrique à l'extérieur de la ligne électrique triphasée (30) a une deuxième valeur différente de la première valeur ; et

un moyen (40) apte à effectuer la détermination de la distance au défaut entre phase et terre (F) à partir du point de mesure (40) sur la base des valeurs de courant et de tension déterminées, **caractérisé en ce que** le moyen (40) apte à effectuer la détermination de la distance est configuré pour utiliser quatre équations dérivables d'un circuit équivalent pour un défaut de phase à terre sur une ligne électrique triphasée pour la détermination de la distance au défaut entre phase et terre (F) à partir du point de mesure (40) de sorte que

la première équation met en relation une partie réelle de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la première valeur ;

la deuxième équation met en relation une partie imaginaire de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la première valeur ;

la troisième équation met en relation la partie réelle de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la deuxième valeur ; et

la quatrième équation met en relation la partie imaginaire de la tension phase-terre de la phase en défaut au point de mesure avec la tension homopolaire du réseau électrique et avec le courant homopolaire, le courant de séquence positive et le courant de séquence négative de la ligne électrique triphasée au point de mesure, lorsque l'admittance du neutre à la terre du réseau électrique à l'extérieur de la ligne électrique triphasée (30) a la deuxième valeur.

**7.** Appareil selon la revendication 6, **caractérisé en ce que** la première équation est :

$$real(\overline{U}_{ph\_t1}) = real(d \cdot \overline{Z}_0 \cdot (\overline{I}_{0\_t1} - \overline{U}_{0\_t1} \cdot \overline{Y}_0 \cdot q)) + real(d \cdot \overline{Z}_1 \cdot \overline{I}_{1\_t1}) + real(d \cdot \overline{Z}_2 \cdot \overline{I}_{2\_t1}) + real(3 \cdot R_F \cdot (\overline{I}_{0\_t1} - \overline{U}_{0\_t1} \cdot \overline{Y}_0))$$

la deuxième équation est :

$$imag(\overline{U}_{ph\_t1}) = imag(d \cdot \overline{Z}_0 \cdot (\overline{I}_{0\_t1} - \overline{U}_{0\_t1} \cdot \overline{Y}_0 \cdot q)) + imag(d \cdot \overline{Z}_1 \cdot \overline{I}_{1\_t1}) + imag(d \cdot \overline{Z}_2 \cdot \overline{I}_{2\_t1}) + imag(3 \cdot R_F \cdot (\overline{I}_{0\_t1} - \overline{U}_{0\_t1} \cdot \overline{Y}_0))$$

la troisième équation est :

$$real(\overline{U}_{ph\_t2}) = real(d \cdot \overline{Z}_0 \cdot (\overline{I}_{0\_t2} - \overline{U}_{0\_t2} \cdot \overline{Y}_0 \cdot q)) + real(d \cdot \overline{Z}_1 \cdot \overline{I}_{1\_t2}) + real(d \cdot \overline{Z}_2 \cdot \overline{I}_{2\_t2}) + real(3 \cdot R_F \cdot (\overline{I}_{0\_t2} - \overline{U}_{0\_t2} \cdot \overline{Y}_0))$$

et la quatrième équation est :

$$imag(\overline{U}_{ph\_t2}) = imag(d \cdot \overline{Z}_0 \cdot (\overline{I}_{0\_t2} - \overline{U}_{0\_t2} \cdot \overline{Y}_0 \cdot q)) + imag(d \cdot \overline{Z}_1 \cdot \overline{I}_{1\_t2}) + imag(d \cdot \overline{Z}_2 \cdot \overline{I}_{2\_t2}) + imag(3 \cdot R_F \cdot (\overline{I}_{0\_t2} - \overline{U}_{0\_t2} \cdot \overline{Y}_0))$$

où

$U_{ph\text{-}t1}$ = tension phase-terre de la phase en défaut au point de mesure lorsque l'admittance du neutre à la terre du réseau électrique à l'extérieur de la ligne électrique triphasée a la première valeur ;

$\overline{U}_{ph\text{-}t2}$ = tension phase-terre de la phase en défaut au point de mesure lorsque l'admittance du neutre à la terre du réseau électrique à l'extérieur de la ligne électrique triphasée a la deuxième valeur ;

d = distance de défaut entre le point de mesure et l'emplacement de défaut ;

$\overline{Z}_0$ = impédance homopolaire de la ligne électrique triphasée ;

$\overline{Z}_1$ = impédance de séquence positive de la ligne électrique triphasée ;

$\overline{Z}_2$ = impédance de séquence négative de la ligne électrique triphasée ;

$R_F$ = résistance de défaut ;

$\overline{Y}_0$ = admittance de phase à terre de la ligne électrique triphasée par phase ;

$\overline{U}_{0\text{-}t1}$ = tension homopolaire du réseau électrique lorsque l'admittance du neutre à la terre du réseau électrique à l'extérieur de la ligne électrique triphasée a la première valeur ;

$\overline{U}_{0\text{-}t2}$ = tension homopolaire du réseau électrique lorsque l'admittance du neutre à la terre du réseau électrique à l'extérieur de la ligne électrique triphasée a la deuxième valeur ;

$\overline{I}_{0\text{-}t1}$ = courant homopolaire de la ligne électrique triphasée au point de mesure lorsque l'admittance du neutre à la terre du réseau électrique à l'extérieur de la ligne électrique triphasée a la première valeur ;

$\overline{I}_{0\text{-}t2}$ = courant homopolaire de la ligne électrique triphasée au point de mesure lorsque l'admittance du neutre à la terre du réseau électrique à l'extérieur de la ligne électrique triphasée a la deuxième valeur ;

$\overline{I}_{1\text{-}t1}$ = courant de séquence positive de la ligne électrique triphasée au point de mesure lorsque l'admittance du neutre à la terre du réseau électrique à l'extérieur de la ligne électrique triphasée a la première valeur ;

$\overline{I}_{1\_t2}$ = courant de séquence positive de la ligne électrique triphasée au point de mesure lorsque l'admittance du neutre à la terre du réseau électrique à l'extérieur de la ligne électrique triphasée a la deuxième valeur ;

$\overline{I}_{2\text{-}t1}$ = courant de séquence négative de la ligne électrique triphasée au point de mesure lorsque l'admittance du neutre à la terre du réseau électrique à l'extérieur de la ligne électrique triphasée a la première valeur ;

$\overline{I}_{2\text{-}t2}$ = courant de séquence négative de la ligne électrique triphasée au point de mesure lorsque l'admittance du neutre à la terre du réseau électrique à l'extérieur de la ligne électrique triphasée a la deuxième valeur ;

q = facteur de distribution du courant homopolaire de la ligne électrique triphasée.

8. Appareil selon la revendication 6 ou 7, **caractérisé en ce que** l'appareil comprend un moyen apte à effectuer le changement de l'admittance du neutre à la terre du réseau électrique à l'extérieur de la ligne électrique triphasée (30) de la première valeur à la deuxième valeur en connectant ou en déconnectant une résistance parallèle d'une bobine de compensation ou en changeant un degré de compensation de la bobine de compensation.

9. Appareil selon la revendication 6, 7 ou 8, **caractérisé en ce que** l'appareil comprend un moyen (40) apte à effectuer la détermination de la résistance de défaut en utilisant lesdites quatre équations correspondant au circuit équivalent pour le défaut entre phase et terre sur une ligne électrique triphasée.

10. Appareil selon l'une quelconque des revendications 6 à 9, **caractérisé en ce que** l'appareil comprend un relais de protection.

Fig. 1

**Fig. 2**

'pos.- seq. Network'

'neg.- seq. Network'

'zero- seq. Network'

Measuring point

Fault location

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1939638 A
- EP 2000811 A
- US 20090267611 A
- US 20060291113 A
- US 20080297163 A

### Non-patent literature cited in the description

- **J. ALTONEN ; A. WAHLROOS.** Advancements in fundamental frequency impedance based earth-fault location in unearthed distribution networks. *CIRED,* 2007
- **J. ALTONEN ; A. WAHLROOS.** Advancements in earth-fault location in compensated MV-networks. *CIRED,* 2011
- **S. HÄNNINEN ; M. LEHTONEN.** Earth fault distance computation with fundamental frequency signals based on measurements in substation supply bay. *VTT Research Notes 2153,* 2002
- **P. SCHEGNER ; G. EBERL.** Computation of the earth fault distance in compensated MV-networks by evaluating steady-state values. *PSCC,* 2002